# EUROPEAN PATENT APPLICATION

(11) **EP 4 535 598 A1**
(43) Date of publication of application: **09.04.2025**
(21) Application number: 23219340.9
(22) Date of filing: 21.12.2023
(51) Int. Cl.: H02J 7/00, H02J 7/02

(54) **BATTERY CHARGER COMPATIBLE WITH AC/DC POWER SOURCES**

(30) Priority: 06.10.2023 TW 112138449
(71) Applicant: DHC Specialty Corp., Taipei (TW)
(72) Inventor: HO, Pai-Yuan, TAIPEI (TW); CHENG, Chao-Lung, TAIPEI (TW); YANG, Henry, TAIPEI (TW); WANG, David, TAIPEI (TW)
(74) Representative: Melchior, Robin

(57) **Abstract**

A battery charger compatible with AC/DC power sources (1) is provided and comprises a power output port (50) connected to a battery (4), a rectifier (30) connected between an AC connecting port (10) and the power output port (50), and a power conversion unit (40) connected between a DC connecting port (20) and the power output port (50). When the AC connecting port (10) receives an AC power, the rectifier (30) rectifies the AC power into a DC power and outputs the DC power to the power output port (50). When the DC connecting port (20) receives an DC input power and the AC power is not received by the AC connecting port (10), the power conversion unit (40) transforms the DC input power into the DC power and outputs the DC power to the power output port (50).

## Description

### BACKGROUND

### 1. Field of the Invention

The present invention relates to a battery charger, and more particularly to a battery charger compatible with AC/DC power sources.

### 2. Description of the Prior Arts

Generally, a 12-volt (V) vehicle battery will be provided in a fuel vehicle for starting an engine. When the vehicle has not been used for a long time, some electrical equipment in the vehicle stays in a standby mode and consumes electricity continuously, causing a power of the vehicle battery to decrease over time. That is, when the vehicle has not been used for a long time, the vehicle battery of the vehicle will be depleted, making the vehicle unable to start. Therefore, when the vehicle battery is depleted, the vehicle battery needs to be charged to restart the vehicle. The vehicle battery can be charged via mains by electrically connecting to a conventional battery charger. The conventional battery charger can rectify a 120V alternating current (AC) power into a direct current (DC) power and provide the DC power to the vehicle battery for charging. The vehicle battery can also be directly connected to a DC power source, such as another fully charged vehicle battery, through a battery wire, so that a DC power outputted by the vehicle battery of another vehicle can be used for charging.

However, the conventional battery charger is connected to the mains to receive the AC power and provides the AC power to the vehicle battery for charging. Because the battery wire of the vehicle battery is used to connect the vehicle battery of other vehicles, the battery wire cannot be electrically connected to mains-sockets. In other words, when a vehicle owner needs to charge the vehicle battery of a stalled vehicle, the vehicle owner needs to carry the conventional battery charger that can be connected to the mains and the battery wire that can receive the DC power at the same time to use a DC power source or an AC power source to charge the vehicle battery.

For example, if the vehicle has been parked in a parking lot for a long time and the vehicle battery is depleted, the vehicle battery needs to be charged. Although the parking lot has mains-sockets, if the vehicle owner does not carry the conventional battery charger, the vehicle owner cannot directly charge the vehicle battery through the mains-sockets. The vehicle owner needs to rely on other vehicle owners to provide the vehicle batteries for charging. For another example, if the vehicle has been parked in the suburbs for a long time and the vehicle battery is depleted, the vehicle battery needs to be charged. It is difficult to find the mains-sockets in the suburbs. When the vehicle owner does not carry the battery wire, even if other vehicles are passing by, the vehicle owner does not have the battery wire to connect other vehicle batteries for charging the vehicle battery. In order not to miss any opportunity to charge the vehicle battery, the vehicle owner must carry the conventional battery charger and the battery wire that can receive the DC power at the same time. The problem is that in a limited space of the vehicle, carrying the conventional battery charger and the battery wire at the same time is inconvenient and takes up too much space, which may easily burden the vehicle owner.

### SUMMARY OF THE INVENTION

The present invention provides a battery charger compatible with AC/DC power sources that can combine a function of receiving an AC power to charge a battery and a function of receiving a DC power to charge the battery in a single charger, providing users with a possibility of using the DC power or the AC power to charge the battery. The battery charger of the present invention that combines the two functions into a single charger will be more convenient to carry and reduce a carrying burden of the users.

The battery charger compatible with AC/DC power sources comprises a power output port, an AC connecting port, a rectifier, a DC connecting port and a power conversion unit.

The power output port is electrically connected to a battery. The rectifier comprises a rectifying input terminal and a rectifying output terminal. The rectifying input terminal is electrically connected to the AC connecting port. The rectifying output terminal is electrically connected to the power output port.

When the AC connecting port is connected to an AC power source to receive an AC power from the AC power source, the rectifier receives the AC power from the rectifying input terminal, rectifies the AC power into a DC power and outputs the DC power to the power output port through the rectifying output terminal.

The power conversion unit comprises a power conversion input terminal and a power conversion output terminal. The power conversion input terminal is electrically connected to the DC connecting port. The power conversion output terminal is electrically connected to the power output port.

When the DC connecting port is connected to a DC power source to receive a DC input power from the DC power source while the AC power is not received from the AC connecting port, the power conversion unit receives the DC input power from the power conversion input terminal to transform the DC input power into the DC power and outputs the DC power to the power output port through the power conversion output terminal.

In an embodiment, the AC power source is the mains and the AC connecting port is a mains-plug for connecting to a mains-socket. The DC power source is a portable power source, and the DC connecting port is a USB PD port or a USB QC port, such as a USB Type-A connecting port or a USB Type-C connecting port. The DC connecting port of the present invention can obtain the DC input power through the portable power source. Regardless that a voltage of the DC input power is high or low, the DC input power can be used to charge the battery which is electrically connected to the power output port at an appropriate voltage after being converted by the power conversion unit. When there is no power provided by the AC power source, the users of the present invention can use the portable DC power source to charge the battery. That is to say, the users only need to carry the battery charger compatible with AC/DC power sources of the present invention, and the battery can be directly charged by the AC power or the DC power without carrying the additional battery wire.

### BRIEF DESCRIPTION OF THE DRAWINGS

Fig. 1 is a block diagram of the battery charger compatible with AC/DC power sources of the present invention.
Fig. 2A is a perspective view of the battery charger compatible with AC/DC power sources of the present invention.
Fig. 2B is another perspective view of the battery charger compatible with AC/DC power sources of the present invention.
Fig. 3A is a schematic diagram of the battery voltage waveform information of the battery charger of the present invention.
Fig. 3B is a schematic diagram of the charging current waveform information of the battery charger of the present invention.
Fig. 4 is an operation flow chart of the battery charger compatible with AC/DC power sources of the present invention.
Fig. 5 is another operation flow chart of the battery charger compatible with AC/DC power sources of the present invention.

### DETAILED DESCRIPTION OF THE INVENTION

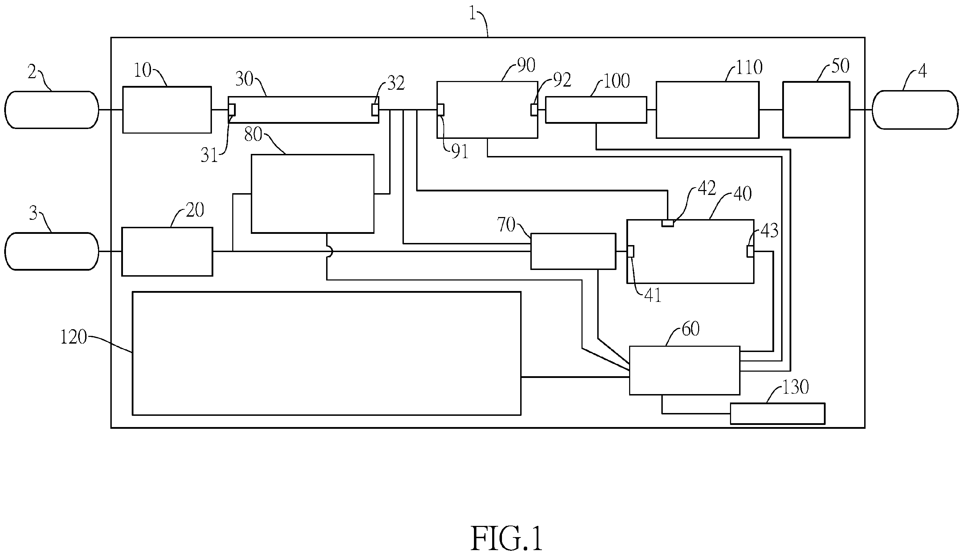

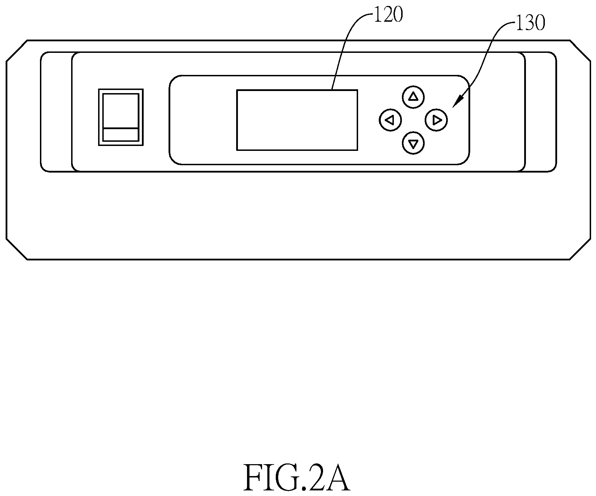

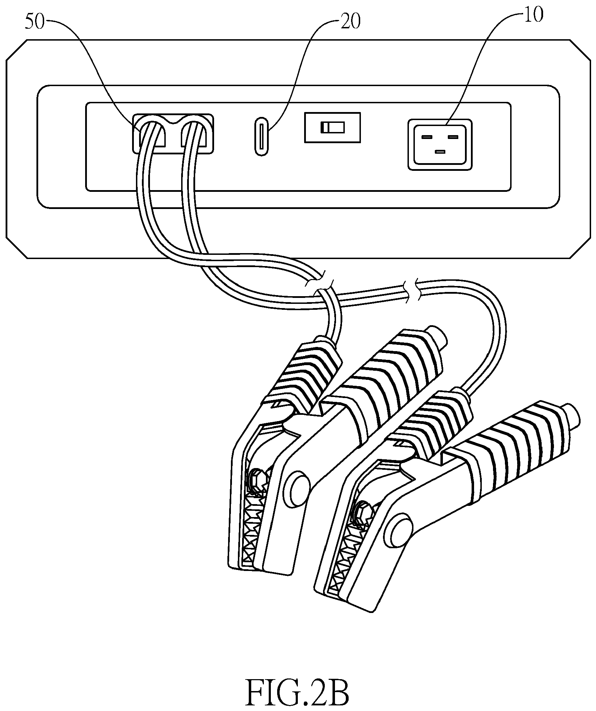

With reference to Figs. 1, 2A and 2B, the present invention provides a battery charger 1 compatible with AC/DC power sources. The battery charger 1 compatible with AC/DC power sources comprises an AC connecting port 10, a DC connecting port 20, a rectifier 30, a power conversion unit 40 and a power output port 50.

In an embodiment of the present invention, the AC connecting port 10 is electrically connected to an AC power source 2 and the DC connecting port 20 is electrically connected to a DC power source 3. The power output port 50 is electrically connected to a battery. In this embodiment, the battery is a battery 4 of a vehicle, and the battery can also be other types of batteries in other embodiments, such as industrial deep-cycle batteries or Uninterruptible Power Source (UPS) batteries, etc.

In this embodiment, the AC power source 2 can be, for example, mains of 100 Volts (V) to 240 V, and the AC power source 2 outputs an AC power to the AC connecting port 10 through a mains-socket.

The AC connecting port 10 is used to connect a mains-plug of the mains-socket. The DC power source 3 can be, for example, a portable power source. The portable power source has a USB Type-C power output port and a function of Power Delivery (PD) power source protocol. The portable power source outputs an DC input power through a USB PD port or a USB QC port to the DC connecting port 20. The battery 4 is a lead-acid battery, which can supply a 12 V power when fully charged. However, when the battery 4 is incompletely charged, a voltage supplied by the battery 4 will drop.

The rectifier 30 is electrically connected to the AC connecting port 10 and the power output port 50. The rectifier 30 comprises a rectifying input terminal 31 and a rectifying output terminal 32. In a preferred embodiment of the present invention, the rectifying input terminal 31 is electrically connected to the AC connecting port 10 and the rectifying output terminal 32 is electrically connected to the power output port 50. When the AC connecting port 10 receives an AC power from the AC power source 2, the rectifier 30 receives the AC power from the rectifying input terminal 31, rectifies the AC power into a DC power and outputs the DC power to the power output port 50 through the rectifying output terminal 32.

The power conversion unit 40 is electrically connected between the DC connecting port 20 and the power output port 50. The power conversion unit 40 comprises a power conversion input terminal 41, a power conversion output terminal 42, and a power conversion control terminal 43. In a preferred embodiment of the present invention the power conversion input terminal 41 is electrically connected to the DC connecting port 20. The power conversion output terminal 42 is electrically connected to the power output port 50. The power conversion output terminal 42 of the power conversion unit 40 is electrically connected to the rectifying output terminal 32 of the rectifier 30.

When the DC connecting port 20 receives the DC input power from the DC power source 3 while the AC power is not received from the AC connecting port 10, the power conversion unit 40 receives the DC input power from the power conversion input terminal 41 to transform the DC input power into the DC power and outputs the DC power to the power output port 50 through the power conversion output terminal 42.

When the DC connecting port 20 receives the DC input power from the DC power source 3 and the AC connecting port 10 receives the AC power from the AC power source 2 at the same time, the power conversion unit 40 stops outputting the DC power and only the rectifier 30 outputs the DC power to the power output port 50. The DC power outputted to the power output port 50 is used to charge the battery 4 which is electrically connected to the power output port 50.

Compared with the conventional technology, a conventional battery charger needs to use a mains power or connect to batteries of other vehicles through traditional battery wires to charge the battery 4 when the battery 4 is depleted. The battery charger 1 compatible with AC/DC power sources provided by the present invention can combine a function of receiving an AC power of other vehicle batteries to charge a battery and a function of receiving a DC power of other vehicle batteries to charge the battery in a single charger, providing users with a possibility of using the DC power or the AC power to charge the battery 4.

When there is no power source from the AC power source 2, users of the present invention can use the portable DC power source 3 to charge the battery 4. In this way, the users only need to carry the battery charger 1 compatible with AC/DC power sources of the present invention to charge the battery 4 by using the DC power or the AC power, and does not need to carry additional battery wires. The battery charger 1 of the present invention that combines the two functions into a single charger will be more convenient to carry and reduce a carrying burden of the users.

In an embodiment of the present invention, the battery charger 1 of the present invention further comprises a processing unit 60, a control unit 70, a system power management unit 80, a pulse width modulation (PWM) control unit 90, a voltmeter 100, a reverse protection unit 110, a display unit 120 and a button unit 130. The processing unit 60 is electrically connected to the power conversion control terminal 43 of the power conversion unit 40, the control unit 70, the system power management unit 80, the PWM control unit 90, the voltmeter 100, a display unit 120 and a button unit 130.

The system power management unit 80 is electrically connected between the rectifying output terminal 32 of the rectifier 30 and the DC connecting port 20. The system power management unit 80 senses whether the DC power is received through the rectifying output terminal 32 and whether the DC input power is received through the DC connecting port 20. The system power management unit 80 generates a power status signal according to a sensing result about whether the DC power is received through the rectifying output terminal 32 or the DC input power is received through the DC connecting port 20 and the system power management unit 80 outputs the power status signal to the processing unit 60.

When the processing unit 60 determines the rectifying output terminal 32 outputs the DC power and the DC connecting port 20 outputs the DC input power according to the power status signal generated by the system power management unit 80, the processing unit 60 controls the power conversion unit 40 to stop outputting the DC power through the power conversion output terminal 42. That is, when the processing unit 60 determines the battery charger 1 of the present invention receives a power of the AC power source 2 and a power of the DC power source 3 at the same time to charge the battery 4, the processing unit 60 controls the battery charger 1 of the present invention to preferentially use the power of the AC power source 2 to charge the battery 4. The reason is that, the AC power source 2 is usually the mains and the DC power source 3 is usually the portable power source carried by the users. Charging the battery 4 by the power of the AC power source 2 can ensure that the user's portable power source still retains the power required for emergencies.

The power conversion unit 40 mentioned above can be a DC to DC transformer and a transformation ratio of the transformer can be dynamically adjusted under the control of the processing unit 60. For example, when the DC input power has a voltage, which is significantly lower than a voltage that the DC power should have, the processing unit 60 controls the power conversion unit 40 to increase a voltage boosting factor. When the DC input power has the voltage, which is approximately equal to the voltage that the DC power should have, the processing unit 60 controls the power conversion unit 40 to stabilize the DC input power and output the DC input power to the PWM control unit 90. When the DC input power has the voltage, which is greater than the voltage that the DC power should have, the processing unit 60 can also control the power conversion unit 40 to buck the DC input power.

Regardless of a voltage value of the DC input power, the power conversion unit 40 of the present invention can electrically convert the DC input power to an appropriate voltage, so that the battery 4 can be charged by the outputted DC power at an appropriate voltage.

In addition, when the processing unit 60 determines the DC power is not outputted by the rectifying output terminal 32 and the DC connecting port 20 outputs the DC input power according to the power status signal generated by the system power management unit 80, the processing unit 60 controls the power conversion unit 40 to transform the DC input power into the DC power and outputs the DC power through the power conversion output terminal 42. That is, when there is no power source from the AC power source 2, the processing unit 60 controls the battery charger 1 of the present invention to use the power of the DC power source 3 to charge the battery 4.

When the processing unit 60 determines the rectifying output terminal 32 outputs the DC power and the DC input power is not outputted by the DC connecting 20 according to the power status signal generated by the system power management unit 80, the processing unit 60 controls the battery charger 1 of the present invention to use the power of the AC power source 2 to charge the battery 4.

The control unit 70 is further connected in series between the DC connecting port 20 and the power conversion input terminal 41 of the power conversion unit 40. The power conversion input terminal 41 of the power conversion unit 40 is electrically connected to the DC connecting port 20 through the control unit 70.

When the DC connecting port 20 receives the DC input power through the DC power source 3, the control unit 70 executes a handshake protocol with the DC power source 3. The control unit 70 of the present invention can accept a variety of charging protocols. For example, the control unit 70 can accept a PD charging protocol which is used by the PD port of the USB or a charging protocol which is used by the QC port of the USB.

The present invention does not limit the types of the charging protocols that the control unit 70 can accept, so the present invention does not limit the types of the supported handshake protocols, but the control unit 70 can only accept the charging protocols that can be defined by the control unit 70.

When the control unit 70 determines the handshake protocol which is executed with the DC power source 3 is successful, the control unit 70 determines that a charging protocol used by the DC power source 3 can be defined by the present invention. The control unit 70 generates a protocol information about the charging protocol used by the DC power source 3 to the processing unit 60, for example, allowing the processing unit 60 to confirm that the DC power source 3 will use a PD charging protocol. The processing unit 60 receives a power type information of the DC power source 3 according to the protocol information. The processing unit 60 controls the power conversion unit 40 to transform the DC input power into the DC power according to the protocol information. For example, the processing unit 60 stores a data table. When the power type information corresponds to the PD charging protocol, the processing unit 60 controls the power conversion unit 40 to increase a voltage of the DC input power to output the DC power according to a data table.

When the control unit 70 determines the handshake protocol fails, the control unit 70 determines that the charging protocol used by the DC power source 3 cannot be defined by the present invention. The control unit 70 shuts down the power conversion input terminal 41 of the power conversion unit 40. The control unit 70 forms a short circuit between the DC connecting port 20 and the power conversion unit 40 to decline the battery charger 1 of the present invention from using the undefined charging protocol. In this way, the control unit 70 can protect the battery charger 1 of the present invention from overvoltage or overcurrent caused by undefined charging protocols. Therefore, after receiving the protocol information outputted by the control unit 70, the processing unit 60 understands how to process the DC input power inputted by the DC power source 3 into subsequent power into a power for charging the battery 4. The processing unit 60 must charge the battery 4 after knowing how to charge the battery 4 to protect the battery 4 and make the battery 4 healthy and safe.

In this embodiment, the PWM control unit 90, the voltmeter 100 and the reverse protection unit 110 are arranged in series between the rectifying output terminal 32 of the rectifier 30 and the power output port 50. The rectifying output terminal 32 of the rectifier 30 is electrically connected to the power output port 50 through the PWM control unit 90, the voltmeter 100 and the reverse protection unit 110.

The PWM control unit 90, the voltmeter 100 and the reverse protection unit 110 are arranged in series between the power conversion output terminal 42 of the power conversion unit 40 and the power output port 50. The power conversion output terminal 42 of the power conversion unit 40 is electrically connected to the power output port 50 through the PWM control unit 90, the voltmeter 100 and the reverse protection unit 110.

The voltmeter 100 is electrically connected to the power output port 50 through the reverse protection unit 110. The reverse protection unit 110 allows the voltmeter 100 to sense a voltage of the power output port 50. The voltmeter 100 senses a voltage of the power output port 50 to generate a voltage signal and outputs the voltage signal to the processing unit 60.

When neither the rectifying output terminal 32 of the rectifier 30 nor the power conversion output terminal 42 of the power conversion unit 40 outputs the DC power to the power output port 50 and the battery 4 is electrically connected to the power output port 50, the battery 4 outputs a battery power to the power output port 50. The voltage signal sensed by the voltmeter 100 represents a voltage of the battery power. The processing unit 60 can determine a health status of the battery 4 and calculate a battery power percentage according to the built-in battery data and the voltage signal received from the voltmeter 100 regarding the voltage of the battery power.

The processing unit 60 has a built-in memory, and the built-in memory stores a voltage charging schedule, a charging current threshold, a charging control setting, a battery abnormality waveform information 205, and multiple charging stage waveform information. When starting to charge the battery 4, the processing unit 60 starts to time a cumulative charging time for charging the battery 4 and calculates a cumulative charging energy for charging the battery 4. The cumulative charging energy corresponds to an energy used to charge the battery 4. A unit of account of the cumulative charging energy can be, for example, Ampere-Hour (Ah) to calculate an amount of charge used within a period of time. The processing unit 60 calculates a charging progress and a charging current value based on the voltage charging schedule and the voltage signal and calculates an estimated charging completion time based on the charging progress and the charging current.

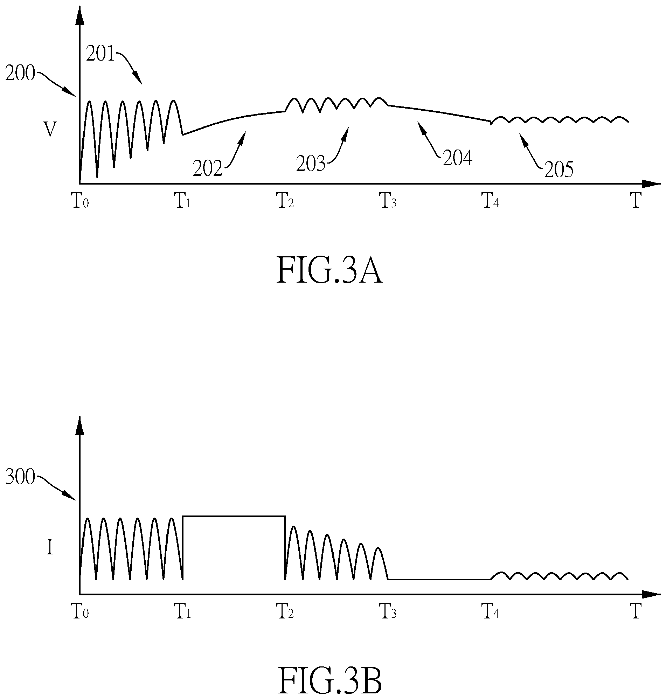

With reference to Figs. 3A and 3B, when the processing unit 60 receives the voltage signal from the voltmeter 100, the processing unit 60 continuously records changes of the voltage signal to generate a battery voltage waveform information 200. Fig. 3A shows a schematic diagram of the battery voltage waveform information 200. In Fig. 3A, a unit of a vertical axis is voltage (V), and a unit of a horizontal axis is time (T). The processing unit 60 continuously monitors an amount of power outputted to the battery 4 by the battery charger 1. Therefore, the processing unit 60 generates a charging current waveform information 300 which is corresponding to the battery voltage waveform information 200 according to the power outputted to the battery 4 and the battery voltage waveform information 200. Fig. 3B shows a schematic diagram of the charging current waveform information 300. In Fig. 3B, a unit of a vertical axis is current (C), and a unit of a horizontal axis is time (T) also. The schematic diagrams of Figs. 3A and 3B present the time correspondence between the battery voltage waveform information 200 and the charging current waveform information 300.

When charging the battery 4, the processing unit 60 continuously records the changes of the battery voltage waveform information 200 to determine whether the battery voltage waveform information 200 matches the battery abnormality waveform information 205 and whether the voltage signal is greater than the first voltage threshold.

When the processing unit 60 determines the battery voltage waveform information 200 matches the battery abnormality waveform information 205, the processing unit 60 generates a battery abnormality notification to report that the health status of the battery 4 is abnormal and the battery 4 needs to be inspected and maintained. In the example of Fig. 3A, the processing unit 60 determines that the health status of the battery 4 is abnormal and the battery 4 should be inspected and maintained at a fourth time T4. When the processing unit 60 determines that the charging current value is greater than the charging current threshold, the processing unit 60 controls the power conversion unit 40 to reduce the current flow of the DC power outputted through the power conversion output terminal 42 to ensure the charging safety.

When the processing unit 60 determines that the battery voltage waveform information 200 does not match the battery abnormality waveform information 205 and determines that the charging current value is less than or equal to the charging current threshold, the processing unit 60 determines that the battery 4 is in a safe state which means the battery 4 is normally charged. The processing unit 60 further determines whether the battery voltage waveform information 200 matches one of the charging stage waveform information.

With reference to Figs. 3A and 3B, under normal circumstances, multiple charging stages can be divided into four different stages in this embodiment, such as a first stage, a second stage, a third stage and a fourth stage. In this embodiment, the first stage starts at a start time T0 and ends at a first time T1, the second stage starts at the first time T1 and ends at a second time T2, the third stage starts at the second time T2 and ends at a third time T3, and the fourth stage starts at the third time T3 and ends at the fourth time T4. These four charging stages have their own characteristics. For example, the first stage has a first voltage waveform information 201, the second stage has a second voltage waveform information 202, the third stage has a third voltage waveform information 203, and the fourth stage has a fourth voltage waveform information 204. Therefore, the processing unit 60 can determine the current charging stage based on the battery voltage waveform information 200 to know how to safely control the power conversion unit 40 to convert the voltage of the DC power to an appropriate voltage.

Preferably, the built-in memory of the processing unit 60 further stores a first voltage threshold, a second voltage threshold and a third voltage threshold. The third voltage threshold is greater than the second voltage threshold, and the second voltage threshold is greater than the first voltage threshold. The charging control setting has a plurality of charging control setting contents which are respectively corresponding to the first stage, the second stage, the third stage and the fourth stage.

During normal charging, the processing unit 60 determines whether the current voltage signal sensed by the voltmeter 100 is greater than the first voltage threshold. When the processing unit 60 determines that the voltage signal is greater than the first voltage threshold, the processing unit 60 controls the PWM control unit 90 to change a waveform mode which changes the first stage to the second stage for modulating the DC power into the output power.

The processing unit 60 further starts to determine whether the voltage signal is greater than the second voltage threshold. When the processing unit 60 determines that the voltage signal is greater than the second voltage threshold, the processing unit 60 controls the PWM control unit 90 to change the waveform mode which changes the second stage to the third stage for modulating the DC power into the output power.

The processing unit 60 further starts to determine whether the voltage signal is greater than the third voltage threshold. When the processing unit 60 determines that the voltage signal is greater than the third voltage threshold, the processing unit 60 controls the PWM control unit 90 to change the waveform mode which changes the third stage to the fourth stage for modulating the DC power into the output power.

The first stage corresponds to a most depleted state of the battery 4. Under the first stage, the processing unit 60 controls the PWM control unit 90 to charge the battery 4 with a larger power. Under the second stage, the processing unit 60 controls the PWM control unit 90 to charge the battery 4 with a smaller power and a constant current to prevent the battery 4 from overheating. Under the third stage, after moderately cooling the battery 4, the processing unit 60 controls the PWM control unit 90 to charge the battery 4 with a power which is smaller than the power of the first stage but greater than the power of the second stage. Under the fourth stage, the battery 4 is nearly fully charged, so the processing unit 60 controls the PWM control unit 90 to charge the battery 4 with a power which is smaller than the power of the second stage. The present invention can closely match the characteristics of the battery 4 and has a function of formulating different charging plans at different stages to protect the battery 4 from overcharging or overheating.

Preferably, the built-in memory of the processing unit 60 further also stores a temperature threshold and a battery voltage and temperature comparison table. The processing unit 60 can further determine a current temperature state of the battery 4 by comparing the voltage signal to the battery voltage and temperature comparison table. Furthermore, the processing unit 60 further determines whether the current temperature state of the battery 4 is greater than the temperature threshold. When the processing unit 60 determines that the temperature state is greater than the temperature threshold, the processing unit 60 generates a battery overheating notification.

The PWM control unit 90 performs Pulse Width Modulation to the DC power output by the rectifying output terminal 32 of the rectifier 30 or the power conversion output terminal 42 of the power conversion unit 40. The PWM control unit 90 has a PWM input terminal 91 and a PWM output terminal 92. The PWM input terminal 91 is connected to the rectifying output terminal 32 of the rectifier 30 and the power conversion output terminal 42 of the power conversion unit 40 in parallel. The PWM output terminal 92 is electrically connected to the voltmeter 100.

When the processing unit 60 receives the voltage signal from the voltmeter 100, the processing unit 60 controls the PWM control unit 90 to modulate the DC power received by the PWM input terminal 91 according to the voltage signal and the charging control setting. After modulating the DC power, the PWM control unit 90 generates an output power and outputs the output power to the voltmeter 100, the reverse protection unit 110 and the power output port 50 which are connected in series through the PWM output terminal 92.

The reverse protection unit 110 senses whether the output power outputted to the power output port 50 through the voltmeter 100 has a reverse current. When the reverse protection unit 110 determines the output power has the reverse current, the reverse protection unit 110 closes the power output port. The reverse protection unit 110 and the power output port 50 are disconnected to protect the battery charger 1 from being damaged by the reverse current.

In this embodiment, the processing unit 60 further controls the display unit 120 to display a lot of information that needs to be informed by the user. For example, the processing unit 60 controls the display unit 120 to display the power type information of the DC power source 3, a current voltage value of the power output port 50 sensed according to the voltage signal, the cumulative charging time calculated by the processing unit 60, the cumulative charging energy calculated by the processing unit 60, the charging progress, the charging current value, the estimated charging completion time, the charging stage and the charging current threshold.

The power type information displayed by the display unit 120 can include, for example, the information about the AC, the DC, the DC-USB PD, the DC-QC 3.0, and others. The voltage values displayed by the display unit 120 can include, for example, an output voltage of the battery 4 when using the AC power source 2 or the DC power source 3 to charge the battery 4 or the output voltage of the battery 4 when not using the AC power source 2 or the DC power source 3 to charge the battery. The charging progress displayed by the display unit 120 can be, for example, a percentage value or a graph showing the percentage value, such as a bar graph. The charging stage displayed by the display unit 120 can include, for example, the battery abnormality notification, the battery overheating notification, a battery temperature overcooling notification, a charging notification, a charging completion notification, a charging voltage over-high notification, the charging voltage over-low notification, a battery voltage mode detecting notification, a notification for maintaining the charging voltage, and a non-connected notification for the battery 4 is not connected to the battery charger 1.

In this embodiment, the display unit 120 can include a Liquid-Crystal Display (LCD) and an LCD module driver (LCM driver). The LCM driver is electrically connected between the processing unit 60 and the LCD. The processing unit 60 controls operations of the LCM driver to control the LCD to display the above information.

The button unit 130 can include multiple buttons. When the button unit 130 is triggered by the users, the button unit 130 generates a setting signal to the processing unit 60. The processing unit 60 updates the charging control setting according to the setting signal. The processing unit 60 updates other types of data stored in the built-in memory of the processing unit 60 according to the received setting signal, such as updating a setting of the charging current threshold.

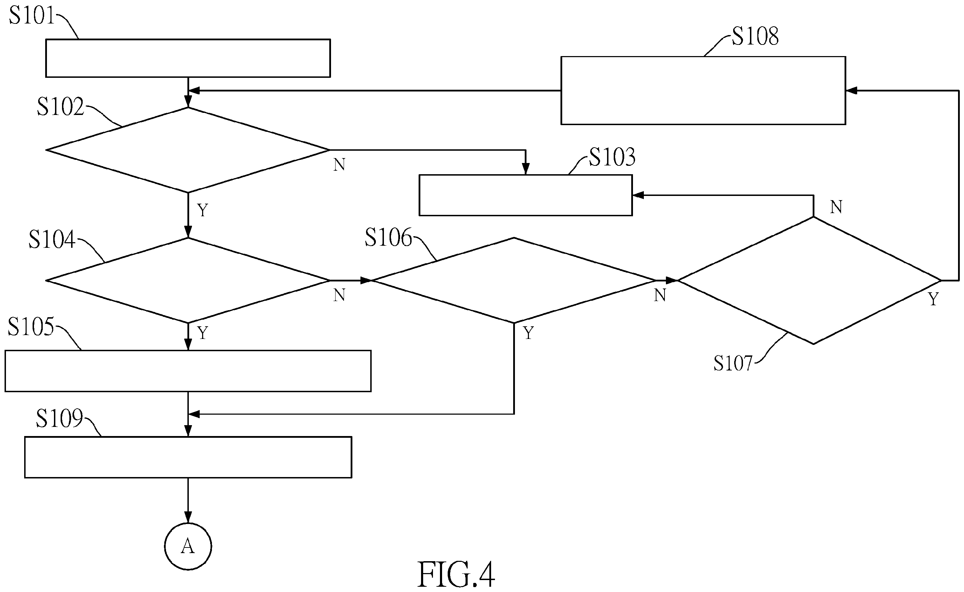

With reference to Fig. 4, in an embodiment, the operation of the battery charger 1 compatible with AC/DC power sources of the present invention is executed by the processing unit 60. The operation of the battery charger 1 compatible with AC/DC power sources comprises the following steps:
Step101: system initializing. For example, initializing the system of the battery charger 1 when the user boots up the battery charger 1.
Step102: detecting whether all peripheral components are normal. For example, detecting whether all components electrically connected to the processing unit 60 are operating normally.
Step103: when any abnormal peripheral component is detected, generating an error code which is corresponding to the abnormal peripheral component.
Step104: when all peripheral components are detected to be normal, detecting whether the rectifier 30 generates the AC power after receiving the AC power from the AC power source 2 according to the system power management unit 80.
Step105: when the AC power received from the AC power source 2 is detected, that is, when the system power management unit 80 detects that the rectifier 30 generates the AC power, shutting down the control unit 70 to make the power conversion unit 40 stop outputting the DC power through the power conversion output terminal 42 and directly executing step S109.
Step106: when the AC power received from the AC power source 2 is not detected, detecting whether the DC input power is received from the DC power source 3 according to the system power management unit 80. When the DC input power received from the DC power source 3 is detected, directly executing the step S109.
Step107: When the DC input power received from the DC power source 3 is not detected, detecting whether the battery 4 is electrically connected to the power output port 50 and let the voltmeter 100 read the voltage of the battery 4. When the voltage of the battery 4 is not read by the voltmeter 100, executing the step S103 to generate a corresponding abnormal information.
Step108: When the voltage of the battery 4 is read by the voltmeter 100, generating the battery voltage mode detecting notification and executing the step S102.
Step109: generating the charging notification. With reference to Fig. 4, the processing unit 60 further executes the following steps:
   Step110: determining whether the read voltage of the battery 4 is greater than 0 V.
   Step111: when determining the read voltage of the battery 4 is less than or equal to 0 V, stop outputting the output power to the battery 4 and executing step S112.
   Step112: after stopping outputting the output power to the battery 4, executing a standby state and executing the step S110.
   Step113: when determining the read voltage of the battery 4 is greater than 0 V, further determining whether the voltage of the battery 4 is less than 14.8 V.
   Step114: when determining the read voltage of the battery 4 is greater than or equal to 14.8 V, generating the charging voltage over-high notification and executing step S115.
   Step115: stopping charging the battery 4.
   Step116: when determining the read voltage of the battery 4 is greater than 0 V and less than 14.8 V, initializing the charging setting, starting charging the battery 4 and starting to calculate the cumulative charging time.
   Step117: determining whether the cumulative charging time exceeds a charging limit time.
   Step118: when determining the cumulative charging time exceeds the charging limit time, generating a charging timeout notification and executing the step S115.
   Step119: when determining the cumulative charging time is less than or equal to the charging limit time, determining whether the battery 4 is abnormal.
   Step120: when determining the battery 4 is abnormal, generating the corresponding battery abnormality notification and executing the step S115.
   Step121: when determining the battery 4 is normal, determining whether a restart button of the button unit 130 is triggered. When determining the restart button of the button unit 130 is triggered, executing the step S116. When determining the restart button of the button unit 130 is not triggered, executing the step S110.

### LIST OF REFERENCE NUMERALS

In figure 1:
- 2: AC POWER SOURCE
- 3: DC POWER SOURCE
- 4: BATTERY
- 10: AC CONNECTING PORT
- 20: DC CONNECTING PORT
- 30: RECTIFIER
- 40: POWER CONVERSION UNIT
- 50: POWER OUTPUT PORT
- 60: PROCESSING UNIT
- 70: CONTROL UNIT
- 80: SYSTEM POWER MANAGEMENT UNIT
- 90: PWM CONTROL UNIT
- 100: VOLTMETER

- 110: REVERSE PROTECTION UNIT
- 120: DISPLAY UNIT
- 130: BUTTON UNIT

In figure 4:
- S101: SYSTEM INITIALIZING.
- S102: DETECTING WHETHER ALL PERIPHERAL COMPONENTS ARE NORMAL?
- S103: GENERATING AN ERROR CODE.
- S104: DETECTING WHETHER THE AC POWER IS RECEIVED?
- S105: MAKING THE POWER CONVERSION UNIT STOP OUTPUTTING THE DC POWER.
- S106: DETECTING WHETHER THE DC POWER IS RECEIVED?
- S107: DETECTING WHETHER THE VOLTMETER READS THE VOLTAGE OF THE BATTERY?
- S108: GENEARTING THE BATTERY VOLTAGE MODE DETECTING NOTIFICATION.
- S109: GENEARTING THE CHARGING NOTIFICATION.

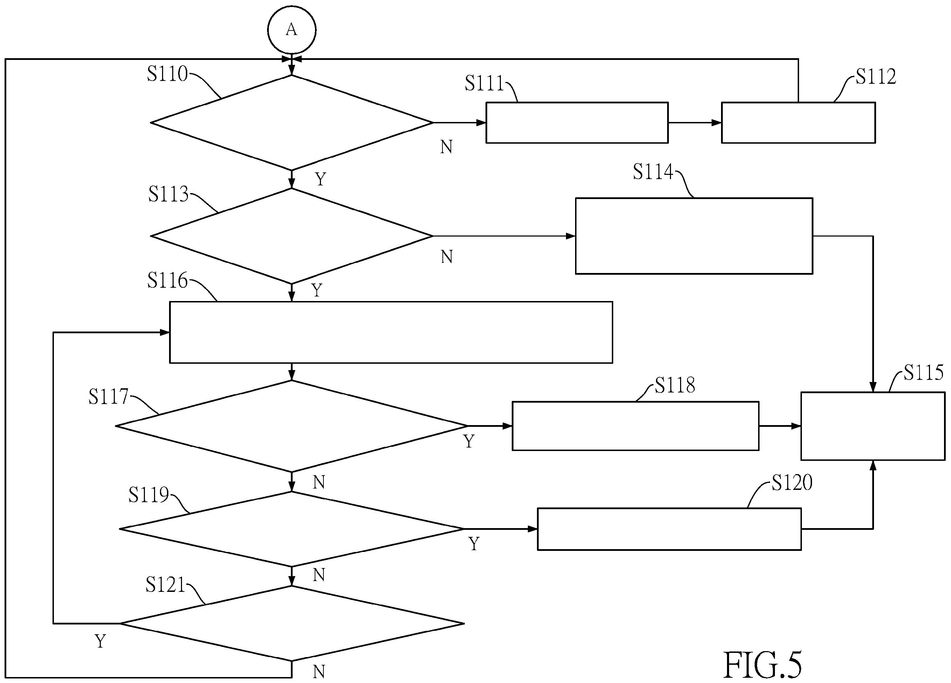

In figure 5:
- 5110: DETERMINING WHETHER THE VOLTAGE OF THE BATTERY IS GREATER THAN 0 V?
- Sill: STOP OUTPUTTING THE OUTPUT POWER.
- S112: EXECUTING A STANDBY STATE.
- S113: DETERMINING WHETHER THE VOLTAGE OF THE BATTERY IS LESS THAN 14.8 V?
- S114: GENEARTING THE CHARGING VOLTAGE OVER-HIGH NOTIFICATION.
- S115: STOP CHARGING THE BATTER.
- S116: INITIALIZING THE CHARGING SETTING, STARTING CHARGING THE BATTERY AND STARTING TO CALCULATE THE CUMULATIVE CHARGING TIME.
- S117: DETERMINING WHETHER THE CUMULATIVE CHARGING TIME EXCEEDS A CHARGING LIMIT TIME?
- S118: GENERATING A CHARGING TIMEOUT NOTIFICATION.
- S119: DETERMINING WHETHER THE BATTERY IS ABNORMAL?
- S120: GENERATING THE BATTERY ABNORMALITY NOTIFICATION.
- S121: DETERMINING WHETHER A RESTART BUTTON IS TRIGGERED?

## Claims

1. A battery charger compatible with AC/DC power sources (1), **characterized in that** the battery charger (1) comprising:
a power output port (50), electrically connected to a battery (4);
an AC connecting port (10);
a rectifier (30), comprising:
a rectifying input terminal (31), electrically connected to the AC connecting port (10); and
a rectifying output terminal (32), electrically connected to the power output port (50); wherein
when the AC connecting port (10) is connected to an AC power source (2) to receive an AC power from the AC power source (2), the rectifier (30) receives the AC power from the rectifying input terminal (31), rectifies the AC power into a DC power and outputs the DC power to the power output port (50) through the rectifying output terminal (32);
a DC connecting port (20);
a power conversion unit (40), comprising:
a power conversion input terminal (41), electrically connected to the DC connecting port (20); and
a power conversion output terminal (42), electrically connected to the power output port (50); wherein
when the DC connecting port (20) is connected to a DC power source (3) to receive a DC input power from the DC power source (3) while the AC power is not received from the AC connecting port (10), the power conversion unit (40) receives the DC input power from the power conversion input terminal (41) to transform the DC input power into the DC power and outputs the DC power to the power output port (50) through the power conversion output terminal (42) .

2. The battery charger (1) as claimed in claim 1, further comprising:
a system power management unit (80), electrically connected to the rectifying input terminal (31) of the rectifier (30) and the DC connecting port (20), wherein the system power management unit (80) senses whether the DC power is received through the rectifying output terminal (32) and whether the DC input power is received through the DC connecting port (20) to generate a power status signal; and
a processing unit (60), electrically connected to the system power management unit (80) and the power conversion unit (40); wherein
when the processing unit (60) determines the rectifying output terminal (32) outputs the DC power and the DC connecting port (20) outputs the DC input power according to the power status signal generated by the system power management unit (80), the processing unit (60) controls the power conversion unit (40) to stop outputting the DC power through the power conversion output terminal (42) ;
when the processing unit (60) determines the DC power is not outputted by the rectifying output terminal (32) and the DC connecting port (20) outputs the DC input power according to the power status signal generated by the system power management unit (80), the processing unit (60) controls the power conversion unit (40) to transform the DC input power into the DC power and output the DC power through the power conversion output terminal (42).

3. The battery charger (1) as claimed in claim 2, further comprising:
a control unit (70), electrically connected to the DC connecting port (20), the power conversion input terminal (41) of the power conversion unit (40) and the processing unit (60); wherein
when the DC connecting port (20) receives the DC input power through the DC power source (3), the control unit (70) executes a handshake protocol with the DC power source (3);
when the handshake protocol is successful, the control unit (70) generates a protocol information to the processing unit (60) and the processing unit (60) controls the power conversion unit (40) to transform the DC input power into the DC power according to the protocol information;
when the handshake protocol fails, the control unit (70) shuts down the power conversion input terminal (41) of the power conversion unit (40).

4. The battery charger (1) as claimed in claim 1, further comprising:
a display unit (120), electrically connected to the processing unit (60); wherein
when the processing unit (60) receives the protocol information, the processing unit (60) receives a power type information of the DC power source (3) according to the protocol information and controls the display unit (120) to display the power type information.

5. The battery charger (1) as claimed in claim 1, further comprising:
a voltmeter (100), electrically connected to the power output port (50) and sensing a voltage of the power output port (50) to generate a voltage signal;
a display unit (120); and
a processing unit (60), electrically connected to the voltmeter (100) and the display unit (120); wherein the processing unit (60) controls the display unit (120) to display the voltage of the power output port (50) according to the voltage signal.

6. The battery charger (1) as claimed in claim 5, wherein the processing unit (60) stores a voltage charging schedule;
the processing unit (60) calculates a charging progress and a charging current value based on the voltage charging schedule and the voltage signal, and the processing unit (60) controls the display unit (120) to display the charging progress and the charging current.

7. The battery charger (1) as claimed in claim 6, wherein the processing unit (60) calculates an estimated charging completion time based on the charging progress and the charging current, and the processing unit (60) controls the display unit (120) to display the estimated charging completion time.

8. The battery charger (1) as claimed in claim 6, wherein the processing unit (60) stores a charging current threshold;
the processing unit (60) controls the display unit (120) to display the charging current threshold, and the processing unit (60) determines whether the charging current is greater to the charging current threshold;
when the charging current is greater than the charging current threshold, the processing unit (60) controls the power conversion unit (40) to reduce a current of the DC power through the power conversion output terminal (42).

9. The battery charger (1) as claimed in claim 5, wherein the processing unit (60) stores a battery abnormality waveform information (205);
when the processing unit (60) receives the voltage signal from the voltmeter (100), the processing unit (60) continuously records changes of the voltage signal to generate a battery voltage waveform information (200) ;
when the processing unit (60) determines the battery voltage waveform information (200) matches the battery abnormality waveform information (205), the processing unit (60) generates a battery abnormality notification.

10. The battery charger (1) as claimed in claim 1, further comprising:
a pulse width modulation (PWM) control unit (90), comprising a PWM input terminal (91) and a PWM output terminal (92); wherein the PWM input terminal (91) is connected to the rectifying output terminal (32) of the rectifier (30) and the power conversion output terminal (42) of the power conversion unit (40) in parallel;
a voltmeter (100), electrically connected between the power output port (50) and the PWM output terminal (92) of the PWM control unit (90); wherein the voltmeter (100) senses a voltage of the power output port to generate a voltage signal;
a processing unit (60), electrically connected to the voltmeter (100) and the PWM control unit (90) and comprising a charging control setting; wherein when the processing unit (60) receives the voltage signal from the voltmeter (100), the processing unit (60) controls the PWM control unit (90) to modulate the DC power received by the PWM input terminal (91) into an output power according to the voltage signal and the charging control setting, and outputs the output power to the voltmeter (100) and the power output port (50) through the PWM output terminal (92) .

11. The battery charger (1) as claimed in claim 10, further comprising:
a reverse protection unit (110), electrically connected between the voltmeter (100) and the power output port (50); wherein
the reverse protection unit (110) senses whether the output power outputted to the power output port (50) through the voltmeter (100) has a reverse current;
when the output power has the reverse current, the power output port (50) is closed.

12. The battery charger (1) as claimed in claim 10, further comprising:
a display unit (120), electrically connected to the processing unit (60); wherein the processing unit (60) controls the display unit (120) to display the charging control setting; and
a button unit (130), electrically connected to the processing unit (60); wherein when the button unit (130) is triggered to generate a setting signal to the processing unit (60), the processing unit (60) updates the charging control setting according to the setting signal.

13. The battery charger (1) as claimed in claim 10, wherein the charging control setting has a first voltage threshold, and the processing unit (60) determines whether the voltage signal is greater than the first voltage threshold;
when the voltage signal is greater than the first voltage threshold, the processing unit (60) controls the PWM control unit (90) to change a waveform mode for modulating the DC power into the output power.
